# EUROPEAN PATENT APPLICATION

(11) **EP 4 682 562 A2**
(43) Date of publication of application: **21.01.2026**
(21) Application number: 24784532.4
(22) Date of filing: 21.05.2024
(51) Int. Cl.: G01R 31/392, G01R 31/396, G01R 31/389, G01R 31/52, G01R 27/02, H01M 10/48

(54) **BATTERY DIAGNOSIS APPARATUS AND OPERATION METHOD THEREOF**

(30) Priority: 04.04.2024 KR 20240046226
(71) Applicant: LG Energy Solution, Ltd., Seoul 07335 (KR)
(72) Inventor: LEE, Gyu Yeol, Daejeon 34122 (KR); KIM, Ju Young, Daejeon 34122 (KR); PARK, Yeon Do, Daejeon 34122 (KR)
(74) Representative: Plasseraud IP
(86) International application number: PCT/IB2024/054917
(87) International publication number: WO 2024/209453

(57) **Abstract**

A battery diagnosis apparatus according to an embodiment herein includes an interface configured to obtain a frequency-specific impedance of a voltage applied between each of a plurality of measurement points of a first electrode lead of an inspection target battery cell and a second electrode lead of the battery cell and one or more processors configured to diagnose a state of the battery cell, based on a first impedance that is an impedance between a first point among the plurality of measurement points and the second electrode lead, a second impedance that is an impedance between a second point among the plurality of measurement points and the second electrode lead, and a first impedance variance that is a difference between the first impedance and the second impedance.

## Description

### [TECHNICAL FIELD]

### CROSS-REFERENCE TO RELATED APPLICATION

This application claims priority to and the benefit of Korean Patent Application No. 10-2023-0045021 filed in the Korean Intellectual Property Office on April 5, 2023, and Korean Patent Application No. 10-2024-0046226 filed in the Korean Intellectual Property Office on April 4, 2024, the entire contents of which are incorporated herein by reference.

### TECHNICAL FIELD

Embodiments disclosed herein relate to a battery diagnosis apparatus and an operating method thereof.

### [BACKGROUND ART]

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Recently, the lithium ion battery is attracting attention as a next-generation energy storage medium as a usage range thereof is expanded to a power source of electric vehicles.

An electric vehicle is supplied with electricity from outside to charge a battery cell/module, and then the battery cell/module is discharged to drive a motor and obtain power. The battery cell/module undergoes internal deformation and denaturation through various charges/discharges in production and use phases, such that physical and chemical characteristics thereof change. A technique for diagnosing and managing a state of the battery cell/module due to degradation and deterioration of a battery is required.

For various purposes such as diagnosis, analysis, etc., of the state of the battery cell, a test may be conducted on the battery. For example, when electrochemical impedance spectroscopy (EIS) is used, an abnormal battery cell may be detected based on an impedance of an inspection target battery cell, measured in a specific frequency domain (e.g., a resonant-frequency domain). However, this method may have a problem of a low diagnosis accuracy. Therefore, there is a need for a technique for accurately diagnosing the state of the battery cell.

### [DISCLOSURE]

### [TECHNICAL PROBLEM]

Embodiments disclosed herein aim to provide a battery diagnosis apparatus and an operating method thereof in which an abnormal battery cell may be managed based on impedance data measured at a plurality of measurement points of an electrode lead of a battery cell.

Embodiments disclosed herein aim to provide a battery diagnosis apparatus and an operating method thereof in which a position and a degree of an electrode defect may be diagnosed based on impedance data measured at a plurality of measurement points of an electrode lead of a battery cell.

Technical problems of the embodiments disclosed herein are not limited to the above-described technical problems, and other unmentioned technical problems would be clearly understood by one of ordinary skill in the art from the following description.

### [TECHNICAL SOLUTION]

A battery diagnosis apparatus according to an embodiment herein includes an interface configured to obtain a frequency-specific impedance of a voltage applied between each of a plurality of measurement points of a first electrode lead of an inspection target battery cell and a second electrode lead of the battery cell and one or more processors configured to diagnose a state of the battery cell, based on a first impedance that is an impedance between a first point among the plurality of measurement points and the second electrode lead, a second impedance that is an impedance between a second point among the plurality of measurement points and the second electrode lead, and a first impedance variance that is a difference between the first impedance and the second impedance.

According to an embodiment, the first point and the second point may be spaced apart from each other in a second direction intersecting a first direction in which the first electrode lead protrudes from the battery cell.

According to an embodiment, the first point and the second point may be positioned along a straight line in the second direction.

According to an embodiment, the one or more processors may be further configured to compare the first impedance, the second impedance, and the first impedance variance with a predetermined threshold value and diagnose the battery cell as being in an abnormal state when at least one of the first impedance, the second impedance, and the first impedance variance is greater than the predetermined threshold value.

According to an embodiment, the one or more processors may be further configured to determine the predetermined threshold value based on the frequency-specific impedance measured at each of a first point of a normal battery cell corresponding to the first point and a second point of the normal battery cell corresponding to the second point.

According to an embodiment, the one or more processors may be further configured to diagnose the state of the battery cell, based on a third impedance that is an impedance between a third point among the plurality of measurement points and the second electrode lead, a second impedance variance that is a difference between the second impedance and the third impedance, and a third impedance variance that is a difference between the first impedance and the third impedance.

According to an embodiment, the first point may be spaced from the second point by a first interval in the second direction intersecting the first direction in which the first electrode lead protrudes from the battery cell, and the third point may be spaced from the second point by the first interval in a direction opposite to the second direction.

According to an embodiment, the one or more processors may be further configured to diagnose a position where a defect occurs in the inspection target battery cell, based on a sign of the first impedance variance.

According to an embodiment, the one or more processors may be further configured to diagnose that the defect occurs at the first point in the inspection target battery cell, when the first impedance variance is a positive number and diagnose that the defect occurs at the second point in the inspection target battery cell, when the first impedance variance is a negative number.

According to an embodiment, the one or more processors may be further configured to diagnose that a degree of the defect occurring in the inspection target battery cell is great as any one of a magnitude of the first impedance, a magnitude of the second impedance, and a magnitude of the first impedance variance is greater than the predetermined threshold value.

An operating method of a battery diagnosis apparatus according to an embodiment herein includes obtaining a frequency-specific impedance of a voltage applied between each of a plurality of measurement points of a first electrode lead of an inspection target battery cell and a second electrode lead of the battery cell and diagnosing a state of the battery cell, based on a first impedance that is an impedance between a first point among the plurality of measurement points and the second electrode lead, a second impedance that is an impedance between a second point among the plurality of measurement points and the second electrode lead, and a first impedance variance that is a difference between the first impedance and the second impedance.

According to an embodiment, the first point and the second point may be spaced apart from each other in a second direction intersecting a first direction in which the first electrode lead protrudes from the battery cell.

According to an embodiment, the first point and the second point may be positioned along a straight line in the second direction.

According to an embodiment, the diagnosing may include comparing the first impedance, the second impedance, and the first impedance variance with a predetermined threshold value and diagnosing the battery cell as being in an abnormal state when at least one of the first impedance, the second impedance, and the first impedance variance is greater than the predetermined threshold value.

According to an embodiment, the diagnosing may include determining the predetermined threshold value based on the frequency-specific impedance measured at each of a first point of a normal battery cell corresponding to the first point and a second point of the normal battery cell corresponding to the second point.

According to an embodiment, the diagnosing may include diagnosing the state of the battery cell, based on a third impedance that is an impedance between a third point among the plurality of measurement points and the second electrode lead, a second impedance variance that is a difference between the second impedance and the third impedance, and a third impedance variance that is a difference between the first impedance and the third impedance.

According to an embodiment, the first point may be spaced from the second point by a first interval in the second direction intersecting the first direction in which the first electrode lead protrudes from the battery cell, and the third point may be spaced from the second point by the first interval in a direction opposite to the second direction.

According to an embodiment, the diagnosing may include diagnosing a position where a defect occurs in the inspection target battery cell, based on a sign of the first impedance variance.

According to an embodiment, the diagnosing of the position at which the defect occurs may include diagnosing that the defect occurs at the first point in the inspection target battery cell, when the first impedance variance is a positive number and diagnose that the defect occurs at the second point in the inspection target battery cell, when the first impedance variance is a negative number.

According to an embodiment, the diagnosing may include diagnosing that a degree of the defect occurring in the inspection target battery cell is great as any one of a magnitude of the first impedance, a magnitude of the second impedance, and a magnitude of the first impedance variance is greater than the predetermined threshold value.

### [ADVANTAGEOUS EFFECTS]

A battery diagnosis apparatus and an operating method thereof disclosed herein may manage an abnormal battery cell based on impedance data measured at a plurality of measurement points of an electrode lead of a battery cell.

A battery diagnosis apparatus and an operating method thereof disclosed herein may diagnose a position and a degree of an electrode defect based on impedance data measured at a plurality of measurement points of an electrode lead of a battery cell.

Moreover, various effects recognized directly or indirectly from the disclosure may be provided.

### [DESCRIPTION OF DRAWINGS]

FIG. 1 is a block diagram of a battery pack according to an embodiment disclosed herein.
FIG. 2 is a block diagram of a battery diagnosis apparatus according to an embodiment disclosed herein.
FIG. 3 is a view showing an inner side of a battery cell according to an embodiment disclosed herein.
FIG. 4 is a view showing a method of measuring an impedance of an electrode lead of a battery cell, according to an embodiment disclosed herein.
FIG. 5 is a view showing a method, performed by a battery management apparatus, of diagnosing an abnormal battery cell based on a reactance, according to an embodiment disclosed herein.
FIG. 6 is a flowchart of an operation of a battery diagnosis apparatus according to an embodiment disclosed herein.
FIG. 7 is a block diagram showing a hardware configuration of a computing system for performing an operating method of a battery diagnosis apparatus, according to an embodiment disclosed herein.

### [MODE FOR INVENTION]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

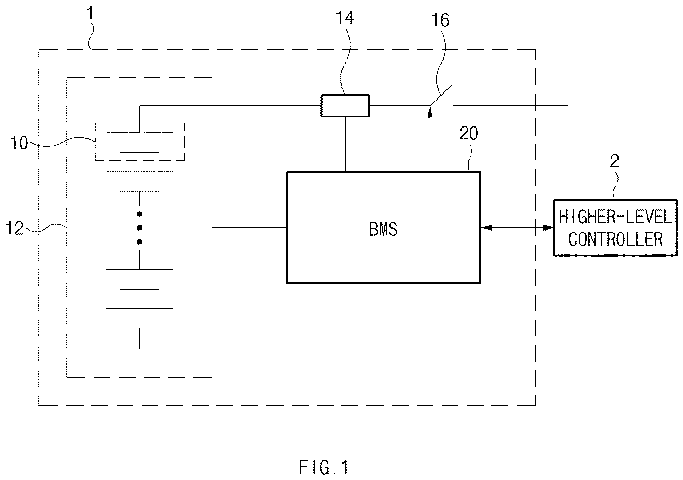

It should be appreciated that various embodiments of the present disclosure and the terms used therein are not intended to limit the technological features set forth herein to particular embodiments and include various changes, equivalents, or replacements for a corresponding embodiment. FIG. 1 is a block diagram of a battery pack according to an embodiment disclosed herein.

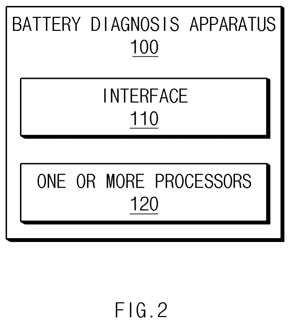

FIG. 2 is a block diagram of a battery diagnosis apparatus according to an embodiment disclosed herein.

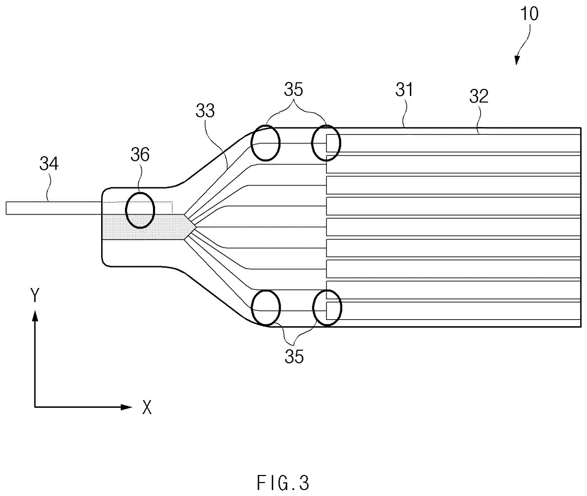

FIG. 3 is a view showing an inner side of a battery cell according to an embodiment disclosed herein.

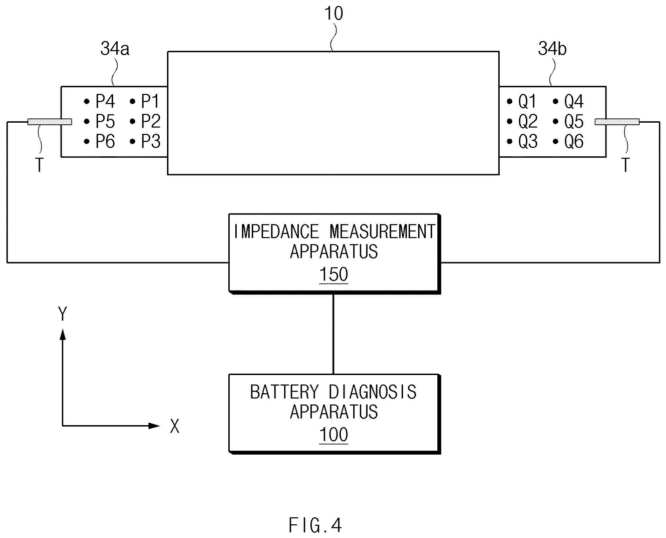

FIG. 4 is a view showing a method of measuring an impedance of an electrode lead of a battery cell, according to an embodiment disclosed herein.

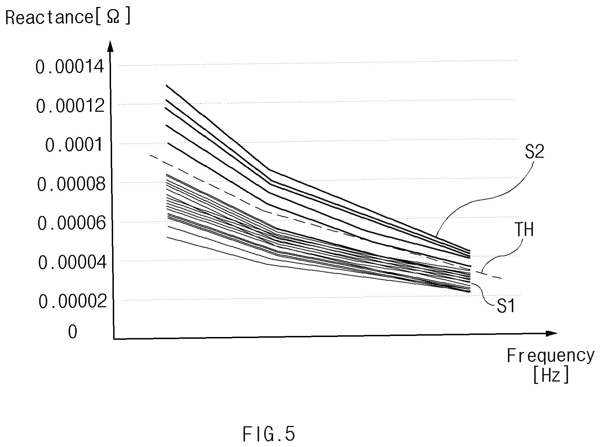

FIG. 5 is a view showing a method, performed by a battery management apparatus, of diagnosing an abnormal battery cell based on a reactance, according to an embodiment disclosed herein.

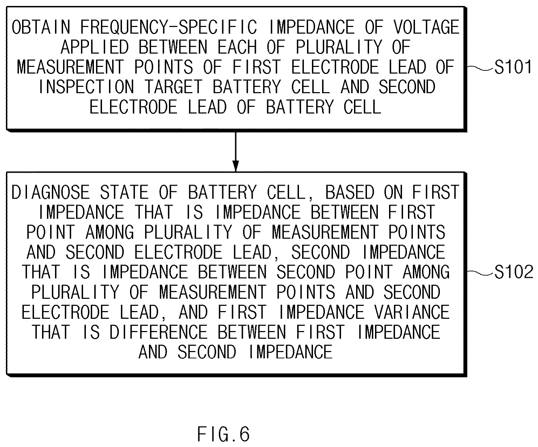

FIG. 6 is a flowchart of an operation of a battery diagnosis apparatus according to an embodiment disclosed herein.

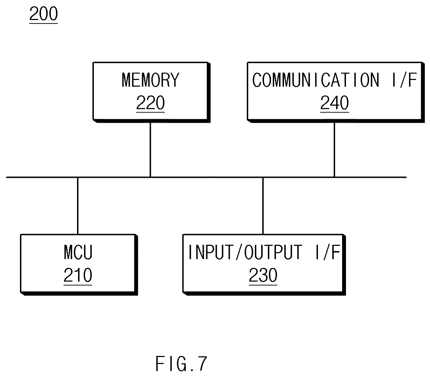

FIG. 7 is a block diagram showing a hardware configuration of a computing system for performing an operating method of a battery diagnosis apparatus, according to an embodiment disclosed herein. With regard to a description, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

FIG. 1 is a block diagram of a battery pack according to an embodiment disclosed herein.

Referring to FIG. 1, a battery pack 1 may include a battery unit 12, a sensor unit 14, a switching unit 16, and a battery management system (BMS) 20. The battery pack 1 may include the battery unit 12, the sensor unit 14, the switching unit 16, and the BMS 20 provided in plural.

According to an embodiment, the battery unit 12 may supply power to a target device (not shown). To this end, the battery unit 12 may be electrically connected to the target device. Herein, the target device may include an electrical, electronic, or mechanical device that operates by receiving power from the battery pack 1. For example, the target device may be, but not limited to, an electric vehicle (EV) or an energy storage system (ESS).

According to an embodiment, the battery unit 12 may include at least one chargeable/dischargeable battery cell 10. Herein, the battery cell 10 may be a basic unit of a battery cell available through charging/discharging of electric energy. For example, the battery cell 10 may be a lithium ion (Li-ion) battery, an Li-ion polymer battery, a nickel-cadmium (Ni-Cd) battery, a nickel hydrogen (Ni-MH) battery, etc., and is not limited thereto. A detailed structure of the battery cell 10 will be described with reference to FIG. 3.

According to an embodiment, the plurality of battery units 12 may be connected in series or in parallel. For example, the battery unit 12 may be a battery module, a battery bank, or a set of battery cells (cell-to-pack structure).

According to an embodiment, the sensor unit 14 may obtain information related to the battery unit 12. According to an embodiment, the sensor unit 14 may obtain values (or information) related to a state of each battery unit 12. In an embodiment, the values related to the states may include one or more values of voltages, currents, resistances, SOC, SOH, or temperatures of a battery cell or combinations thereof.

According to an embodiment, the sensor unit 14 may provide information about each of the plurality of battery units 12 to the BMS 20.

According to an embodiment, the switching unit 16 may include a component for controlling a current flow regarding charging or discharging of the battery unit 12. For example, the switching unit 16 may include at least one relay and/or magnetic contactor, etc., according to the specifications of the battery pack 1.

According to an embodiment, the BMS 20 may monitor a voltage, a current, a temperature, etc., of the battery pack 1 to control or manage the battery pack 1 so as to prevent over-charging, over-discharging, etc. For example, the BMS 20, which is an interface for receiving measurement values of the above-described various parameter values, may include a plurality of terminals and a circuit, etc., connected thereto to process input values. The BMS 20 may control the sensor unit 14 and/or the switching unit 16. For example, the BMS 20 may be connected to the plurality of battery units 12 to monitor a state of each of the plurality of battery units 12 and control ON/OFF of a relay, a contactor, etc.

According to an embodiment, an operation of the BMS 20 may also be performed in not only the BMS in a vehicle, but also various devices such as a server, a cloud, a charger, a charger/discharger, etc.

The higher-level controller 2 may transmit a control signal regarding the plurality of battery units 12 to the BMS 20. Thus, the battery management system 20 may be controlled in terms of an operation thereof based on a signal applied from the higher-level controller 2.

According to an embodiment, the battery management system 20 may include a battery diagnosis apparatus 100 of FIG. 2. According to another embodiment, the battery management system 20 may be different from the battery diagnosis apparatus 100 of FIG. 2. That is, the battery diagnosis apparatus 100 of FIG. 2 may be included in the battery pack 1 and may be configured as another device outside the battery pack 1. Hereinbelow, for convenience of description, it is assumed that the battery diagnosis apparatus 100 includes another device outside the battery pack 1. The following operation of the battery diagnosis apparatus 100 may also be performed in various devices such as not only a battery management system (BMS) in a vehicle, but also a server, a cloud, a charger, a charger/discharger, etc.

FIG. 2 is a block diagram of a battery diagnosis apparatus according to an embodiment disclosed herein. FIG. 3 is a view showing an inner side of a battery cell according to an embodiment disclosed herein. FIG. 4 is a view showing a method of measuring an impedance of an electrode lead of a battery cell, according to an embodiment disclosed herein. FIG. 5 is a view showing a method, performed by a battery management apparatus, of diagnosing an abnormal battery cell based on a reactance, according to an embodiment disclosed herein. The operation of the battery diagnosis apparatus 100 shown in FIG. 2 will be described below in detail with reference to FIGS. 3 to 5.

First, referring to FIG. 2, the battery diagnosis apparatus 100 according to an embodiment disclosed herein may diagnose a state of the battery cell 10 (see FIG. 1). For example, the battery cell 10 may have a defect due to various reasons such as defects at the production stage, internal deformation and denaturation through multiple a plurality of charging and discharging, external shock, etc. Herein, the defect may include tab disconnection, electrode failure, lithium precipitation, etc., in the battery cell 10. The battery diagnosis apparatus 100 according to an embodiment may diagnose abnormality in the battery cell 10 based on an impedance measured in the battery cell 10.

Referring to FIG. 3, an electrode assembly 32 may be included in a battery case 31 of the battery cell 10. Herein, the electrode assembly 32 may extend in an X-axis direction that is a longitudinal direction of the battery cell 10, and may be stacked in a Y-axis direction that is a height direction of the battery cell 10. Electrode tabs 33 may protrude from the electrode assembly 32 in the X-axis direction, and the plurality of electrode tabs 33 may be connected to an electrode lead 34.

According to various embodiments, a welding portion between the electrode assembly 32 and the electrode tab 33, a welding portion between the electrode tab 33 and the electrode lead 34, the electrode tab 33, or the electrode lead 34 may be deformed by various physical and chemical external forces applied in a manufacturing process and a use process of the battery cell 10 and may have a defect. Herein, the defect may mean a defect (e.g., lithium precipitation) of the electrode assembly 32, disconnection 35 of the electrode tab 33, a failure 36 of the electrode lead 34, etc. The defect of the battery cell 10 may cause abnormality such as under-voltage, charging/discharging performance degradation and ignition, etc., of the battery cell 10. Thus, when a defect such as lithium precipitation, the tab disconnection 35, the electrode failure 36, etc., occurs in the battery cell 10, an abnormal battery cell may show a resistance pattern that is different from that of a normal battery cell.

According to various embodiments, the battery diagnosis apparatus 100 may detect abnormality of the battery cell 10 based on an impedance variance measured when voltage is applied to the battery cell 10. Herein, an impedance variance of a battery cell may mean an impedance variance of a battery cell with respect to a frequency. However, conventional diagnosis techniques diagnose an abnormal battery cell based on an impedance measured at one position and thus have a low detection rate of the abnormal battery cell.

On the other hand, the battery diagnosis apparatus 100 according to an embodiment may detect abnormality of the battery cell 10 based on an impedance measured at a plurality of measurement points of the electrode lead 34 of the battery cell 10. Herein, the plurality of measurement points may mean two or more measurement points in at least one of a first electrode (e.g., a positive electrode) and a second electrode (e.g., a negative electrode) of the electrode lead 34. In this way, the battery diagnosis apparatus 100 may detect an abnormal behavior of the impedance variance based on the impedance measured at the plurality of measurement points and diagnose the abnormal battery cell.

Referring back to FIG. 2, the battery diagnosis apparatus 100 may include an interface 110 and one or more processors 120. However, the present disclosure is not limited thereto, such that the battery diagnosis apparatus 100 may further include other components, two or more components may be integrated into one component, or one component may be divided into two or more components.

According to an embodiment, the interface 110 may obtain impedance data measured from the electrode lead 34 of an inspection target battery cell. Herein, the interface 110 may mean a component that is capable of wiredly and/or wirelessly communicating with an external device. According to an embodiment, the interface 110 may obtain impedance data by communicating with an impedance measurement device (an electrochemical impedance spectroscopy (EIS) measurement device). The interface 110 may obtain the impedance data by communicating with other infrastructures such as the BMS 20 (see FIG. 1) or the server , the cloud, etc.

According to an embodiment, the inspection target battery cell may be the battery cell 10 of a pouch type shown in FIGS. 1 and 3, and may mean a bidirectional battery cell in which the electrode leads 34 having different polarities are derived from opposite ends of the battery cell 10 in the longitudinal direction. However, the present disclosure is not limited thereto, and the inspection target battery cell may also mean a unidirectional battery cell in which the electrode leads 34 having different polarities are derived from the same end of the battery cell.

Referring to FIG. 4, an impedance measurement device 150 may be connected to the electrode lead 34 of the inspection target battery cell 10 to measure the impedance of the inspection target battery cell 10. The impedance measurement device 150 may be connected to the electrode lead 34 of the battery cell 10 by predetermined connection cable and connection terminal. For example, the impedance measurement device 150 may be connected to a first electrode lead 34a and a second electrode lead 34b through a pair of probes T.

According to an embodiment, the impedance measurement device 150 may measure the impedance of the battery cell 10 with respect to a frequency. For example, the impedance measurement device 150 may mean an EIS measurement device. Herein, the impedance measurement device 150 may apply a small alternating current (AC) signal and/or AC voltage signal to the inspection target battery cell 10 while changing a frequency, and measure a current and/or voltage signal output from the inspection target battery cell 10 in response to the applied signal to obtain a frequency-specific impedance. According to an embodiment, the EIS measurement device 150 may obtain various parameters related to an impedance such as a phase angle, a resistance, a reactance, etc., of the impedance as well as the impedance, with respect to a frequency.

According to an embodiment, the electrode leads 34a and 34b of the inspection target battery cell 10 may include a plurality of measurement points P1 to P6 and Q1 to Q6. For example, the first electrode lead 34a may include the plurality of measurement points P1 to P6, and the second electrode lead 34b may include the plurality of measurement points Q1 to Q6. While each of the electrode leads 34a and 34b includes 6 measurement points in FIG. 4, each of the electrode leads 34a and 34b may include n measurement points corresponding to positions on each electrode lead (n is a natural number greater than or equal to 1), without limited thereto.

According to an embodiment, the impedance measurement device 150 may measure an impedance between one of the plurality of measurement points P1 to P6 of the first electrode lead 34a and one of the plurality of measurement points Q1 to Q6 of the second electrode lead 34b. For example, when each of the electrode leads 34a and 34b includes 6 measurement points as shown in FIG. 4, the impedance measurement device 150 may measure 36 different impedances.

According to an embodiment, when some (or one) of the plurality of electrode tabs 33 (see FIG. 3) are(is) disconnected, a measured impedance may be high as a measurement point of the electrode leads 34a and 34b are close to a portion where the electrode tab 33 is disconnected. Herein, the electrode leads 34a and 34b may be connected to the plurality of electrode tabs 33. Thus, when disconnection occurs in a specific electrode tab, an impedance measured at a measurement point close to an electrode tab where disconnection occurs may be higher than an impedance measured at a measurement point close to a normal electrode tab. For example, when the electrode tab 33 closest to the first point P1 is disconnected, an impedance between the first point P1 of the first electrode lead 34a and the first point Q1 of the second electrode lead 34b may be higher than that between another point, e.g., P2 or P3 of the first electrode lead 34a and another point, e.g., Q2 or Q3 of the second electrode lead 34b.

Thus, when the battery diagnosis apparatus 100 diagnoses abnormality of the battery cell 10 by using the impedance measured at one measurement point of the electrode leads 34a and 34b, the battery diagnosis apparatus 100 may misdiagnose the abnormal battery cell as a normal battery cell, resulting in a lowered accuracy. On the other hand, the battery diagnosis apparatus 100 according to an embodiment may obtain an impedance measured at a plurality of measurement points and accurately diagnose the state of the battery cell based on the obtained impedance. In another aspect, the battery diagnosis apparatus 100 may improve the accuracy of diagnosis by diagnosing the state of the battery cell 10 based on a plurality of impedances.

According to an embodiment, the interface 110 may obtain a frequency-specific impedance between, for example, each of the plurality of measurement points P1 and P2 of the first electrode lead 34a and, for example, a single measurement point Q2 of the second electrode lead 34b of the inspection target battery cell 10. In another aspect, the interface 110 may obtain a first impedance Z1 that is a frequency-specific impedance of an AC voltage applied between the first point P1 of the first electrode lead 34a and the measurement point Q2 of the second electrode lead 34b. The interface 110 may obtain a second impedance Z2 that is a frequency-specific impedance of an AC voltage applied between the second point P2 of the first electrode lead 34a and the measurement point Q2 of the second electrode lead 34b.

According to an embodiment, for one measurement point, e.g., Q2 of the second electrode lead 34b, Y-axis positions of a plurality of measurement points, e.g., P1, P3, and P5 of the first electrode lead 34a may be different from each other. Herein, the Y-axis direction may mean a second direction intersecting the first direction in which the first electrode lead 34a protrudes from the battery cell 10. Thus, the first point P1 of the first electrode lead 34a and the second point P2 of the first electrode lead 34a may be spaced apart from each other in the second direction (Y-axis direction). In another aspect, when one measurement point, e.g., Q2 of the second electrode lead 34b is fixed, the plurality of measurement points, e.g., P1, P3, and P5, of the first electrode lead 34a may not be positioned along the same straight line in the X-axis direction. In this way, the battery diagnosis apparatus 100 may accurately diagnose a point on the Y axis at which the electrode tab 33 having disconnection occurring is positioned in the electrode tabs 33 stacked in the Y-axis direction.

According to an embodiment, when the measurement point, e.g., Q2 of the second electrode lead 34b is the same, the plurality of measurement points, e.g., P1, P2, and P3, of the first electrode lead 34a may be positioned along a straight line in the Y-axis direction. Herein, the plurality of measurement points may include at least two of the first point P1, the second point P2, and/or the third point P3. For example, the first point P1, the second point P2, and the third point P3 may be positioned along a straight line in the second direction (Y-axis direction) intersecting the first direction (X-axis direction) in which the first electrode lead 34a protrudes from the battery cell 10. Thus, when the first point is P1, the second point may be P2 and the third point may be P3; when the first point is P4, the second point may be P5 and the third point may be P6. In this way, the battery diagnosis apparatus 100 may accurately diagnose a point on the Y axis at which the electrode tab 33 having disconnection occurring is positioned in the electrode tabs 33 stacked in the Y-axis direction.

According to an embodiment, the first point P1, the second point P2, and the third point P3 may be positioned spaced apart from each other by a predetermined distance. According to an embodiment, the first point P1 may be spaced apart from the second point P2 by a first interval in the second direction (Y-axis direction), and the third point may be spaced apart from the second point P2 by the first interval in a direction opposite to the second direction. In this way, the battery diagnosis apparatus 100 may compare impedances measured at the first point and the third point spaced above and below from the second point among the plurality of measurement points by the first interval to accurately diagnose a point on the Y axis at which the electrode tab 33 having disconnection occurring is positioned. The battery diagnosis apparatus 100 may accurately diagnose the state of the battery cell when compared to an existing battery diagnosis apparatus, based on impedance variances (i.e., deviations) including an impedance variance between the first point and the second point, an impedance variance between the second point and the third point, and an impedance variance between the first point and the third point.

Referring back to FIGS. 2 and 4, one or more processors 120 may perform operations of the battery diagnosis apparatus 100. For example, the one or more processors 120 may diagnose the state of the battery cell 10 by processing data obtained from the interface 110. According to an embodiment, the one or more processors 120 may determine based on the impedance data with respect to the frequency obtained from the interface 110 whether the battery cell 10 is abnormal, and diagnose the state.

According to an embodiment, the one or more processors 120 may diagnose the state of the battery cell 10 based on the impedance and the impedance variance. Herein, the impedance may be an impedance measured at a fixed specific point, e.g., Q2 of the second electrode lead 34b and an impedance measured at each of the plurality of measurement points, e.g., P1 and P2 of the first electrode lead 34a. The impedance variance may mean a difference between the above-described impedances.

For example, the one or more processors 120 may diagnose the state of the battery cell 10, based on a first impedance Z1 between the first point P1 among the plurality of measurement points and a specific point, e.g., Q2 of the second electrode lead 34b, a second impedance Z2 between the second point P2 among the plurality of measurement points and a specific point, e.g., Q2 of the second electrode lead 34b, and a first impedance variance Z_12 that is a difference between the first impedance Z1 and the second impedance Z2.

According to an embodiment, the one or more processors 120 may compare each of the first impedance Z1, the second impedance Z2, and the first impedance variance Z_12 with a predetermined threshold value. Herein, the predetermined threshold value may refer to an impedance measured at a normal battery cell, and mean a reference value for distinguishing a normal battery cell from an abnormal battery cell. For example, the predetermined threshold value may include a threshold value for the first impedance Z1, a threshold value for the second impedance Z2, and a threshold value for the first impedance variance Z_12.

According to an embodiment, the one or more processors 120 may determine the predetermined threshold value based on an impedance measured at a measurement point of a normal battery cell corresponding to each of the plurality of measurement points of the inspection target battery cell 10. For example, the one or more processors 120 may determine the predetermined threshold value based on a frequency-specific impedance between the first point P1 of the normal battery cell corresponding to the first point P1 of the inspection target battery cell 10 and a measurement point of the normal battery cell corresponding to the measurement point of the second electrode lead 34b of the inspection target battery cell 10. Herein, the predetermined threshold value may mean a range of impedances of the normal battery cell with respect to a frequency. For example, the predetermined threshold value may mean a maximum value or a minimum value of the normal battery cell with respect to a frequency. In this way, the one or more processors 120 may diagnose a battery cell having a higher impedance than the normal battery cell as an abnormal battery cell.

Referring to FIG. 5, the one or more processors 120 may calculate impedance-related parameters with respect to a frequency, and diagnose a state of the battery cell 10 based on one or more parameters. Herein, the impedance-related parameters may mean a phase angle, a resistance, a reactance, etc., of an impedance, etc.

According to an embodiment, the one or more processors 120 may calculate a resistance and a reactance of each of the first impedance Z1, the second impedance Z2, and the first impedance variance Z_12 and compare at least one of the resistance and the reactance with a predetermined threshold value TH to diagnose the state of the battery cell 10. Herein, the predetermined threshold value TH may mean a reference value for distinguishing a normal battery cell S1 from an abnormal battery cell S2. For example, the predetermined threshold value TH may mean a resistance or a reactance calculated based on an impedance measured in the normal battery cell S1. In this way, the battery diagnosis apparatus 100 may diagnose the abnormal battery cell S2 based on at least one of a resistance, which is a real part, and a reactance, which is an imaginary part, of the impedance. Even when the abnormal battery cell S2 is not diagnosed based on the resistance, the battery diagnosis apparatus 100 may diagnose the abnormal battery cell S2 based on the reactance, thus improving the accuracy of diagnosis.

According to an embodiment, when at least one of the first impedance Z1, the second impedance Z2, and the first impedance variance Z_12 is greater than the predetermined threshold value TH, the one or more processors 120 may diagnose the battery cell 10 as being in an abnormal state. Thus, the battery diagnosis apparatus 100 may improve the accuracy of the diagnosis by further comparing the first impedance variance Z_12 with the threshold value TH in comparison to comparing the first impedance Z1 or the second impedance Z2 with the threshold value TH. For example, when the first impedance Z1 and the second impedance Z2 are in a normal range below the threshold value, but the first impedance variance Z_12 is greater than the threshold value, the battery diagnosis apparatus 100 may diagnose abnormality of the battery cell and improve the accuracy of the diagnosis. In this way, the battery diagnosis apparatus 100 may diagnose the state of the battery cell 10 based on an impedance measured at one measurement point, thereby solving a problem of misdiagnosing the abnormal battery cell S2 as the normal battery cell S1.

According to an embodiment, when the plurality of measurement points of the first electrode lead 34a are three measurement points, the one or more processors 120 may diagnose the state of the battery cell 10 based on the impedance, measured at the plurality of measurement points, and the impedance variance. Herein, the impedance may be an impedance measured at a fixed specific point, e.g., Q2 of the second electrode lead 34b and an impedance measured at each of the plurality of measurement points, e.g., P1, P2, and P3 of the first electrode lead 34a. The impedance variance may mean a difference between the above-described impedances.

For example, the one or more processors 120 may diagnose the state of the battery cell 10 based on the first impedance Z1, the second impedance Z2, the third impedance Z3, the first impedance variance Z_12, a second impedance variance Z_23, and a third impedance variance Z_31. Herein, the third impedance Z3 may mean an impedance between the third point P3 and the second electrode lead 34b, the second impedance variance Z_23 may mean a difference between the second impedance Z2 and the third impedance Z3, and the third impedance variance Z_31 may mean a difference between the first impedance Z1 and the third impedance Z3. In this way, the battery diagnosis apparatus 100 may more accurately diagnose the state of the battery cell 10 by further considering the third impedance Z3, the second impedance variance Z_23, and the third impedance variance Z_31 when using three measurement points in comparison to when using two measurement points.

According to an embodiment, the one or more processors 120 may diagnose a position where a defect occurs in the inspection target battery cell 10, based on a sign of an impedance variance. Herein, the defect may include tab disconnection, electrode failure, lithium precipitation, etc., in the battery cell 10.

For example, when the plurality of measurement points of the first electrode lead 34a are two measurement points and disconnection occurs in the electrode tab 33 closest to the first point P1, the first impedance Z1 may be greater than the second impedance Z2. Thus, the first impedance variance Z_12, which is a difference of the second impedance Z2 from the first impedance Z1, may be a positive number. In this way, when the first impedance variance Z_12 is a positive number, the one or more processors 120 may diagnose tab disconnection occurring at the first point P1 of the inspection target battery cell 10.

On the other hand, when disconnection occurs in the electrode tab 33 closest to the second point P2, the first impedance Z1 may be less than the second impedance Z2. Thus, the first impedance variance Z_12, which is the difference of the second impedance Z2 from the first impedance Z1, may be a negative number. In this way, when the first impedance variance Z_12 is a negative number, the one or more processors 120 may diagnose tab disconnection occurring at the second point P2 of the inspection target battery cell 10. Thus, the battery diagnosis apparatus 100 may not only diagnose whether the inspection target battery cell 10 is an abnormal battery cell or a normal battery cell, but also diagnose a correct position in the abnormal battery cell in which a defect occurs.

According to an embodiment, the one or more processors 120 may diagnose a degree of the defect based on a magnitude of the impedance or a magnitude of the impedance variance. Herein, the magnitude of the impedance may mean a value obtained by adding a square of the real part of the impedance and a square of the imaginary part of the impedance and then taking a square root. For example, as any one of the magnitude of the first impedance Z1, the magnitude of the second impedance Z2, and the magnitude of the first impedance variance Z_12 is greater than the predetermined threshold value, the one or more processors 120 may diagnose that the degree of the defect occurring in the inspection target battery cell 10 is great. Herein, the degree of the defect may mean a length of electrode tab disconnection, an area of an electrode failure, the degree (e.g., an amount) of lithium precipitation, or the like, inside the battery cell 10.

According to an embodiment, the one or more processors 120 may diagnose the degree of the defect based on the resistance or reactance of the impedance. For example, as the resistance or reactance of the impedance is greater than the predetermined threshold value, the one or more processors 120 may diagnose that the degree of the defect occurring in the inspection target battery cell 10 is great. Herein, the predetermined threshold value may mean a reference value for distinguishing a normal battery cell from an abnormal battery cell.

According to various embodiments, as the length of disconnection of the electrode tab 33 increases, the magnitude of the impedance may tend to increase. For example, as the length of disconnection increases, the resistance may increase. Thus, the battery diagnosis apparatus 100 may diagnose the length of disconnection based on the magnitude of the impedance.

According to an embodiment, when the battery cell 10 is diagnosed as having abnormality as a result of diagnosis, the battery diagnosis apparatus 100 may provide information about an abnormal battery cell to a user. For example, the one or more processors 120 may provide information about an abnormal battery cell to a user terminal through a communication circuit (not shown) and provide the information about the abnormal battery cell through a display provided in a vehicle, a charger, etc.

FIG. 6 is a flowchart of an operation of a battery diagnosis apparatus according to an embodiment disclosed herein.

Referring to FIG. 6, the battery diagnosis apparatus 100 may obtain a frequency-specific impedance of a voltage applied between each of a plurality of measurement points of a first electrode lead of an inspection target battery cell and a second electrode lead of the battery cell in operation S101, and diagnose a state of the battery cell based on a first impedance that is an impedance between a first point among the plurality of measurement points and the second electrode lead, a second impedance that is an impedance between a second point among the plurality of measurement points and the second electrode lead, and a first impedance variance that is a difference between the first impedance and the second impedance in operation S102.

In operation S101, the interface 110 of the battery diagnosis apparatus 100 may obtain the impedance with respect to the frequency of the voltage applied between each of the plurality of measurement points of the first electrode lead of the inspection target battery cell and the second electrode lead of the battery cell. Herein, the interface 110 may obtain impedance data from the impedance measurement apparatus 150 or the BMS 20.

In operation S102, the one or more processors 120 of the battery diagnosis apparatus 100 may diagnose the state of the battery cell based on the first impedance, the second impedance, and the first impedance variance. According to an embodiment, when the plurality of measurement points of the first electrode lead are three measurement points, the one or more processors 120 may diagnose the state of the battery cell further based on the third impedance that is an impedance between the third point among the plurality of measurement points and the second electrode lead, the second impedance variance that is a difference between the second impedance and the third impedance, and the third impedance variance that is a difference between the first impedance and the third impedance.

FIG. 7 is a block diagram showing a hardware configuration of a computing system for performing an operating method of a battery diagnosis apparatus, according to an embodiment disclosed herein.

Referring to FIG. 7, a computing system 200 according to an embodiment disclosed herein may include an MCU 210, a memory 220, an input/output I/F 230, and a communication I/F 240.

The MCU 210 may be a processor that executes various programs (e.g., a battery cell data collection program, a graph calculation program, a data analysis program, a data decomposition algorithm, a normalization program, a battery cell diagnosis program, etc.) stored in the memory 220, processes various information including feature data, potential variables, etc., of the battery cell through these programs, and executes the above-described functions of the controller included in the battery diagnosis apparatus 100 shown in FIGS. 1 to 6.

The memory 220 may store various programs such as a battery cell data collection program, a graph calculation program, a data analysis program, a data decomposition algorithm, a normalization program, a battery cell diagnosis program, etc.

The memory 220 may be provided in plural, depending on a need. The memory 220 may be volatile memory or non-volatile memory. For the memory 220 as the volatile memory, random access memory (RAM), dynamic RAM (DRAM), static RAM (SRAM), etc., may be used. For the memory 220 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., to the MCU 210.

The communication I/F 240, which is a component capable of transmitting and receiving various data to and from a server, may be various devices capable of supporting wired or wireless communication. For example, the battery diagnosis apparatus 100 may transmit and receive various information including a shape model, etc., of the battery cell from an external server separately provided through the communication I/F 240.

As such, a computer program according to an embodiment disclosed herein may be recorded in the memory 220 and processed by the MCU 210, thus being implemented as a module that performs functions shown in FIG. 2.

Even though all components constituting an embodiment disclosed herein have been described above as being combined into one or operating in combination, the embodiments disclosed herein are not necessarily limited to the embodiments. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The foregoing disclosure may roughly show features of several embodiments to allow those of ordinary skill in the art to better understand aspects of the present disclosure. Those of ordinary skill in the art will appreciate that they may readily use the present disclosure as a basis for designing or modifying other structures to carry out the same purposes or achieve the same advantages of the embodiments introduced herein. Additionally, it would be recognized by those of ordinary skill in the art that such equivalent configurations may not depart from the scope of the present disclosure and may have various changes, substitutions, and modifications may be made herein without departing from the scope of the present disclosure.

[DESCRIPTION OF SYMBOLS]
1: Battery Pack
2: Higher-Level Controller
10: Battery Cell
12: Battery Unit
14: Sensor Unit
16: Switching Unit
20: BMS
100: Battery Diagnosis Apparatus
110: Interface
120: One or More Processors
150: Impedance Measurement Apparatus
200: Computing System
210: MCU
220: Memory
230: Input/Output I/F
240: Communication I/F

## Claims

1. A battery diagnosis apparatus comprising:
an interface configured to obtain a frequency-specific impedance of a voltage applied between each of a plurality of measurement points of a first electrode lead of an inspection target battery cell and a second electrode lead of the battery cell; and
one or more processors configured to diagnose a state of the battery cell, based on a first impedance that is an impedance between a first point among the plurality of measurement points and the second electrode lead, a second impedance that is an impedance between a second point among the plurality of measurement points and the second electrode lead, and a first impedance variance that is a difference between the first impedance and the second impedance.

2. The battery diagnosis apparatus of claim 1, wherein the first point and the second point are spaced apart from each other in a second direction intersecting a first direction in which the first electrode lead protrudes from the battery cell.

3. The battery diagnosis apparatus of claim 2, wherein the first point and the second point are positioned along a straight line in the second direction.

4. The battery diagnosis apparatus of claim 1, wherein the one or more processors are further configured to:
compare the first impedance, the second impedance, and the first impedance variance with a predetermined threshold value; and
diagnose the battery cell as being in an abnormal state when at least one of the first impedance, the second impedance, and the first impedance variance is greater than the predetermined threshold value.

5. The battery diagnosis apparatus of claim 4, wherein the one or more processors are further configured to determine the predetermined threshold value based on the frequency-specific impedance measured at each of a first point of a normal battery cell corresponding to the first point and a second point of the normal battery cell corresponding to the second point.

6. The battery diagnosis apparatus of claim 1, wherein the one or more processors are further configured to diagnose the state of the battery cell, based on a third impedance that is an impedance between a third point among the plurality of measurement points and the second electrode lead, a second impedance variance that is a difference between the second impedance and the third impedance, and a third impedance variance that is a difference between the first impedance and the third impedance.

7. The battery diagnosis apparatus of claim 6, wherein the first point is spaced from the second point by a first interval in a second direction intersecting a first direction in which the first electrode lead protrudes from the battery cell, and
the third point is spaced from the second point by the first interval in a direction opposite to the second direction.

8. The battery diagnosis apparatus of claim 1, wherein the one or more processors are further configured to diagnose a position where a defect occurs in the inspection target battery cell, based on a sign of the first impedance variance.

9. The battery diagnosis apparatus of claim 8, wherein the one or more processors are further configured to:
diagnose that the defect occurs at the first point in the inspection target battery cell, when the first impedance variance is a positive number; and
diagnose that the defect occurs at the second point in the inspection target battery cell, when the first impedance variance is a negative number.

10. The battery diagnosis apparatus of claim 4, wherein the one or more processors are further configured to diagnose that a degree of the defect occurring in the inspection target battery cell is great as any one of a magnitude of the first impedance, a magnitude of the second impedance, and a magnitude of the first impedance variance is greater than the predetermined threshold value.

11. An operating method of a battery diagnosis apparatus, the operating method comprising:
obtaining a frequency-specific impedance of a voltage applied between each of a plurality of measurement points of a first electrode lead of an inspection target battery cell and a second electrode lead of the battery cell; and
diagnosing a state of the battery cell, based on a first impedance that is an impedance between a first point among the plurality of measurement points and the second electrode lead, a second impedance that is an impedance between a second point among the plurality of measurement points and the second electrode lead, and a first impedance variance that is a difference between the first impedance and the second impedance.

12. The operating method of claim 11, wherein the first point and the second point are spaced apart from each other in a second direction intersecting a first direction in which the first electrode lead protrudes from the battery cell.

13. The operating method of claim 12, wherein the first point and the second point are positioned along a straight line in the second direction.

14. The operating method of claim 11, wherein the diagnosing comprises:
comparing the first impedance, the second impedance, and the first impedance variance with a predetermined threshold value; and
diagnosing the battery cell as being in an abnormal state when at least one of the first impedance, the second impedance, and the first impedance variance is greater than the predetermined threshold value.

15. The operating method of claim 14, wherein the diagnosing comprises determining the predetermined threshold value based on the frequency-specific impedance measured at each of a first point of a normal battery cell corresponding to the first point and a second point of the normal battery cell corresponding to the second point.

16. The operating method of claim 11, wherein the diagnosing comprises diagnosing the state of the battery cell, based on a third impedance that is an impedance between a third point among the plurality of measurement points and the second electrode lead, a second impedance variance that is a difference between the second impedance and the third impedance, and a third impedance variance that is a difference between the first impedance and the third impedance.

17. The operating method of claim 16, wherein the first point is spaced from the second point by a first interval in a second direction intersecting a first direction in which the first electrode lead protrudes from the battery cell, and
the third point is spaced from the second point by the first interval in a direction opposite to the second direction.

18. The operating method of claim 11, wherein the diagnosing comprises diagnosing a position where a defect occurs in the inspection target battery cell, based on a sign of the first impedance variance.

19. The operating method of claim 18, wherein the diagnosing of the position at which the defect occurs comprises:
diagnosing that the defect occurs at the first point in the inspection target battery cell, when the first impedance variance is a positive number; and
diagnosing that the defect occurs at the second point in the inspection target battery cell, when the first impedance variance is a negative number.

20. The operating method of claim 14, wherein the diagnosing comprises diagnosing that a degree of the defect occurring in the inspection target battery cell is great as any one of a magnitude of the first impedance, a magnitude of the second impedance, and a magnitude of the first impedance variance is greater than the predetermined threshold value.
